# EUROPEAN PATENT APPLICATION

(11) **EP 4 286 089 A1**
(43) Date of publication of application: **06.12.2023**
(21) Application number: 21923258.4
(22) Date of filing: 24.12.2021
(51) Int. Cl.: B23K 26/57, B23K 26/067, B23K 26/082, H01L 21/52, H01L 33/00

(54) **TRANSFER DEVICE AND TRANSFER SUBSTRATE**

(30) Priority: 28.01.2021 JP 2021012382; 08.04.2021 JP 2021065912; 22.12.2021 JP 2021208401
(71) Applicant: Toray Engineering Co., Ltd., Tokyo 103-0028 (JP)
(72) Inventor: KAZAMA, Koichi, Otsu-shi, Shiga 520-0842 (JP); ARAI, Yoshiyuki, Otsu-shi, Shiga 520-0842 (JP); INAGAKI, Jun, Otsu-shi, Shiga 520-0842 (JP)
(74) Representative: Global IP Europe Patentanwaltskanzlei
(86) International application number: PCT/JP2021/048087
(87) International publication number: WO 2022/163255

(57) **Abstract**

It is an object of the present invention to provide a transfer device and a transfer substrate with which an element can be reliably separated from a transfer substrate and transferred to a receiving substrate. More specifically, the transfer device transfers an element 21 held by an ablation layer 24a from a transfer substrate 22 to a receiving substrate 23 by irradiating an ablation layer 24a of the transfer substrate 22 with an active energy ray B1 to produce ablation, the transfer device comprising a transfer substrate holding unit that holds the transfer substrate 22, a receiving substrate holding unit that holds the receiving substrate 23 so that the ablation layer 24a of the transfer substrate 22 is opposite the receiving substrate 23, and an active energy ray irradiation unit that irradiates the ablation layer 24 of the transfer substrate 22 held by the transfer substrate holding unit 13 with the active energy ray B1, wherein the active energy ray irradiation unit irradiates the ablation layer 24a with the active energy ray B1 at a plurality of locations in the holding region in which one element 21 is held.

## Description

### [TECHNICAL FIELD]

The present invention relates to a transfer device that irradiates a transfer substrate with optical energy and transfers an element to a receiving substrate by laser lift-off.

### [BACKGROUND ART]

In recent years, semiconductor chips have been made smaller for the sake of cost reduction, and efforts have been made to mount these smaller semiconductor chips very precisely. A so-called laser lift-off method is employed in mounting these smaller chips at high speed, in which the surface of the chip that is joined to a transfer substrate is irradiated with a laser beam to produce ablation, and the chip is peeled off from the transfer substrate and urged, thereby transferring the chip to a receiving substrate.

Patent Literature 1 discloses an element transfer device that transfers an element using an ablation technique. With this element transfer device, a laser irradiation device having a laser irradiation unit for generating a laser beam, a reflecting means for reflecting the laser beam in the desired direction from the laser irradiation unit, and a control means for controlling whether or not the laser beam is emitted in conjunction with the reflecting means, is used to selectively irradiate some of a plurality of elements disposed on a transfer substrate with a laser beam to generate ablation. A portion of the element is transferred onto a receiving substrate as a result of this selective ablation. That is, the element is transferred from the transfer substrate to the receiving substrate by laser lift-off.

Also, Patent Literature 2 discloses a technique in which a blistering layer that is provided on a transfer substrate and has an adhesive layer on the front side is irradiated with a laser beam to cause blistering (swelling) in the blistering layer, and an article (element) adhering to an adhesive layer is pushed out by this blistering to separate the article from the transfer substrate.

### [PRIOR ART DOCUMENT]

### [PATENT LITERATURE]

[Patent Literature 1] Japanese Patent Application Publication No. 2006-041500
[Patent Literature 2] Japanese Patent Application Publication (Translation of PCT Application) No. 2014-515883

### [SUMMARY OF THE INVENTION]

### [PROBLEMS TO BE SOLVED BY THE INVENTION]

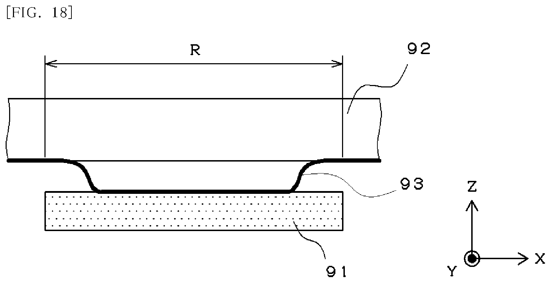

However, with the element transfer devices disclosed in Patent Literatures 1 and 2, even after laser irradiation, there was the risk that the force with which the transfer substrate (transfer source substrate) holds the element would be greater than the force of separating the element, so that the element does not separate from the transfer substrate. In particular, when blistering was produced by ablation in the part of the transfer substrate that held the element, as shown in Fig. 18, even if a single blister 93 was produced by laser irradiation of a holding region R of the transfer substrate 92 where one element 91 was held, a problem was that the contact surface area between the blister 93 and the element 91 remains large, and the force (such as adhesive force) holding the element 91 at this contact surface was greater than the force (such as gravitational force or kinetic energy accompanying the production of the blister) of separating the element 91, and as a result the element 91 did not separate from the transfer substrate 92.

In view of the above problems, it is an object of the present invention to provide a transfer device and a transfer substrate with which an element can be reliably separated from the transfer substrate and transferred to a receiving substrate.

### [MEANS TO SOLVE THE PROBLEMS]

To solve the above problem, the transfer device of the present invention is a transfer device that irradiates an ablation layer of a transfer substrate with an active energy ray to cause ablation, thereby transferring an element held by the ablation layer from the transfer substrate to a receiving substrate, the transfer device comprising a transfer substrate holding unit that holds the transfer substrate, a receiving substrate holding unit that holds the receiving substrate such that the ablation layer of the transfer substrate is opposite the receiving substrate, and an active energy ray irradiation unit that irradiates the ablation layer of the transfer substrate held by the transfer substrate holding unit with an active energy ray, wherein the active energy ray irradiation unit irradiates the ablation layer with an active energy ray at a plurality of locations in a holding region in which one element is held.

With this transfer device, the contact surface area between the ablation layer and the element after irradiation with the active energy ray can be reliably reduced, and the element can be reliably separated from the transfer substrate.

Also, it is preferable if an irradiation range of the active energy ray is smaller than the holding region.

Also, the ablation layer may disappear under ablation.

Also, the ablation layer may blister under ablation.

Also, it is preferable if the active energy ray irradiation unit is configured such that the locations irradiated with the active energy ray are controlled so that the blistering is formed each time the active energy ray is emitted.

This prevents the blisters from coming together and reducing the contact surface area with the element.

Also, it is preferable if the ablation layer is made up of a plurality of independent holding parts, and the plurality of holding parts holding one element are individually irradiated with the active energy ray.

This reduces the contact surface area between the element and the transfer substrate via the holding part, which reduces the output of the active energy ray for transferring one element, and keeps the running cost lower.

Also, in the holding region of the ablation layer, holding parts having an element holding force and in which blistering occurs under irradiation with the active energy ray, and non-holding parts having no element holding force and in which blistering is not produced by the active energy ray may coexist.

This prevents the blisters from coming together and reducing the contact surface area with the element.

Also, it is preferable if the active energy ray irradiation unit irradiates the plurality of holding parts holding one element with the active energy ray in a specific order.

This allows the element to fly off stably in a specific direction.

Also, it is preferable if the active energy ray irradiation unit irradiates the plurality of the holding parts holding one element with an active energy ray in order from an outer holding part to an inner holding part.

This prevents the portion where the element is held from being biased toward one side, and allows the element to fly off stably in a specific direction.

Also, it is preferable if the active energy ray irradiation unit irradiates the plurality of holding parts holding one element with an active energy ray so that the path of irradiation with the active energy ray has a spiral shape.

This allows the element to fly off stably in a specific direction.

Also, it is preferable if the active energy ray emitted from the active energy ray irradiation unit is converted into an energy ray bundle formed of a plurality of active energy rays, and the energy ray bundle simultaneously irradiates all of the holding parts holding one element.

This shortens the time required for transferring a single element.

Also, it is preferable if the active energy ray irradiation unit irradiates all of the holding parts holding one element with an active energy ray of uniform power.

This makes control easier and allows the element to fly off stably in a specific direction.

To solve the above problem, the transfer device of the present invention is a transfer device transfer device that irradiates a transfer substrate with optical energy to transfer a transfer object held by the transfer substrate to a receiving substrate using laser lift-off, comprising a laser beam source that emits laser beam that forms the optical energy, and an optical energy shifting means for adjusting an irradiation position of the optical energy on the transfer substrate, wherein the transfer object is held on the transfer substrate via a plurality of adhesive points provided on a surface of the transfer substrate that is opposite the transfer object, and the laser beam source individually irradiates the plurality of adhesive points holding the one transfer object with the optical energy, thereby transferring the transfer object to the receiving substrate that is disposed opposite the transfer substrate with the transfer object sandwiched therebetween.

With this transfer device, the contact surface area between the transfer object and the transfer substrate via the adhesive points can be reduced, so the output of the laser beam for transferring one transfer object is suppressed, and running costs can be lowered.

Also, to solve the above problem, the transfer substrate of the present invention is a transfer substrate that holds an element with an ablation layer that undergoes ablation when irradiated with an active energy ray, wherein in a holding region for holding one element in the ablation layer, holding parts having an element holding force and in which blistering occurs under irradiation with the active energy ray, and non-holding parts having no element holding force and in which blistering is not produced by the active energy ray coexist.

With this transfer substrate, blisters are prevented from coming together in the holding region and reducing the contact surface area with the element.

### [EFFECTS OF THE INVENTION]

With the transfer device and the transfer substrate of the present invention, an element can be reliably separated from the transfer substrate and transferred to the receiving substrate.

### [BRIEF DESCRIPTION OF THE DRAWINGS]

Fig. 1 consists of diagrams of the transfer device according to a first embodiment of the present invention;
Fig. 2 consists of diagrams of the form of the light rays on a real image plane of laser beam in the transfer device of the first embodiment;
Fig. 3 consists of diagrams illustrating how a chip is held in the transfer device of the present invention;
Fig. 4 consists of diagrams illustrating how a chip is transferred by the transfer device of the first embodiment;
Fig. 5 consists of diagrams illustrating the transfer device in a second embodiment of the present invention;
Fig. 6 consists of diagrams illustrating how a chip is transferred in the transfer device of the second embodiment;
Fig. 7 consists of diagrams illustrating how a chip is transferred in the transfer device of the second embodiment;
Fig. 8 consists of diagrams illustrating the transfer device in a third embodiment of the present invention;
Fig. 9 consists of diagrams illustrating the process of separating an element from a transfer substrate by the transfer device in the third embodiment;
Fig. 10 consists of diagrams illustrating the process of separating an element from a transfer substrate by the transfer device in the third embodiment;
Fig. 11 consists of diagrams illustrating the process of separating an element from a transfer substrate by the transfer device according to another embodiment of the present invention;
Fig. 12 consists of diagrams illustrating a process of separating an element from a transfer substrate by the transfer device according to another embodiment of the present invention;
Fig. 13 consists of diagrams illustrating the transfer substrate in another embodiment of the present invention;
Fig. 14 consists of diagrams illustrating how a chip is transferred according to another embodiment of the present invention;
Fig. 15 consists of diagrams illustrating how a chip is transferred according to another embodiment of the present invention;
Fig. 16 consists of diagrams illustrating how a chip is transferred according to another embodiment of the present invention;
Fig. 17 consists of diagrams illustrating the process of separating an element from a transfer substrate by the transfer device according to another embodiment of the present invention; and
Fig. 18 consists of diagrams illustrating the process of separating an element from a transfer substrate by a conventional transfer device.

### [EMBODIMENTS TO CARRY OUT THE INVENTION]

### First Embodiment

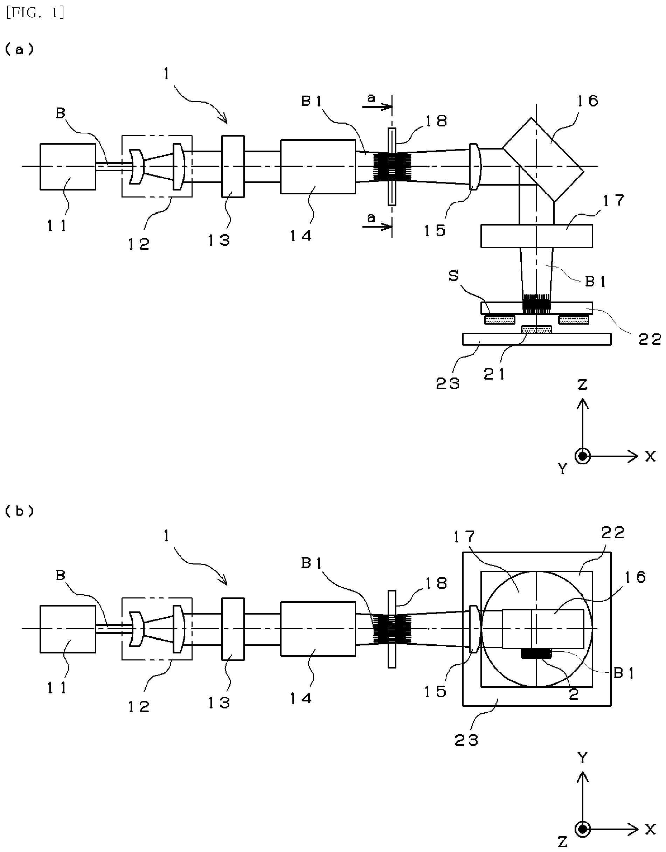

A transfer device 1 according to a first embodiment of the present invention will be described with reference to Fig. 1. Fig. 1(a) is a side view of the transfer device 1, and Fig. 1(b) is a top view of the transfer device 1.

The transfer device 1 of this embodiment irradiates an arbitrary position in the in-plane direction of the irradiated side of the transfer substrate with optical energy consisting of a light spot, thereby transferring a chip 21 (element) held by the transfer substrate to the receiving substrate by laser lift-off. Optical energy is a type of active energy in this description.

The transfer device 1 has a laser irradiation unit 11, a beam expander 12, a phase diffraction element 13, a zoom lens 14, a collimating lens 15, a galvano mirror 16, and an Fθ lens 17. A laser beam B emitted from the laser irradiation unit 11 passes through the beam expander 12, the phase diffraction element 13, the zoom lens 14, the collimating lens 15, the galvano mirror 16, and the Fθ lens 17 in that order, then reaches an irradiated surface S. In the course of this, the phase diffraction element 13 splits the single laser beam B into a light beam bundle B1 (energy ray bundle) formed of a plurality of light beams. In this description, separating a chip from a substrate holding the chip by ablation produced by laser irradiation (laser ablation) is called laser lift-off.

Here, in this embodiment, the irradiated surface S is the surface (lower surface) of the transfer substrate 22 on which the chip 21 is held, and the light beam bundle B1 are transmitted by the transfer substrate 22 before reaching the irradiated surface S. Also, in this description, a collection of parts irradiated with light rays on the irradiated surface S is referred to as a light ray image 2, as shown in Fig. 1(b). When a light beam image 2 is formed on the irradiated surface S, the irradiated surface is irradiated with optical energy according to the irradiation surface area of the light beams constituting the light beam image 2.

In this description, the vertical direction is called the Z axis direction, the horizontal direction in which the laser beam B is emitted from the laser irradiation unit 11 is called the X axis direction, and the horizontal direction perpendicular to the X axis direction is called the Y axis direction.

The laser irradiation unit 11 is what is called an active energy irradiation unit in this description, and is a device that emits a single laser beam B that is an active energy ray. In this embodiment, a laser beam such as a YAG laser or a visible light laser is emitted in pulsed form. The active energy ray is not limited to visible light as in this embodiment, and ultraviolet rays, an electron beam, or the like can also be used.

The beam expander 12 is a combination of lenses for expanding the diameter of the laser beam B emitted from the laser irradiation unit 11, and the beam expander 12 adjusts the diameter of the laser beam B so that the laser beam B will be incident on the phase diffraction element 13 in a diameter suitable for the splitting performed by the phase diffraction element 13.

The phase diffraction element (diffractive optical element: DOE) 13 is configured by combining a plurality of diffraction gratings with different grating periods, and uses the diffraction phenomenon of light to convert the shape of the laser beam B into the desired shape. The phase diffraction element 13 used in this embodiment converts a single laser beam B into a light beam bundle B1 made up of a plurality of light beams arranged in a matrix with an equal pitch in a specific plane (in the YZ plane when the laser beam B is incident from the X axis direction). Here, with the phase diffraction element 13 configured as above, not only the shape of the light beam but also the power of the light beam can be designed as desired, and in this embodiment, the phase diffraction element 13 is designed such that the light beams forming the light beam bundle B1 all have uniform power.

A DOE splits a laser beam into a plurality of light beams obtained as a diffraction pattern by a diffraction grating, and a light intensity distribution consisting of the desired diffraction pattern on is obtained in a virtual plane at a specific distance from the DOE. Therefore, the desired light intensity distribution usually cannot be obtained on surfaces other than the one at the specific distance. Consequently, although the expression "splits a laser beam into a plurality of light beams" as used in this specification is not correct in a strict sense, for the sake of convenience, obtaining a light intensity distribution consisting of a plurality of diffraction patterns by means of the above-mentioned DOE shall simply be referred to as splitting into a plurality of light beams.

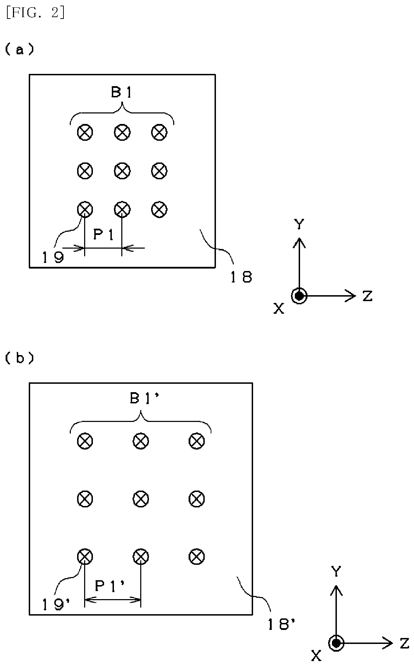

Fig. 2 is a cross sectional view along the a-a line in Fig. 1(a), showing the real image plane of the light beam bundle B1. As discussed above, in this embodiment, the phase diffraction element 13 converts the laser beam B into a light beam bundle B1 made up of a plurality of light beams arranged in a matrix with an equal pitch in the YZ plane, and in the real image plane, a number of light spots equal to the number of light beams forming the light beam bundle B1 are arranged at an equal pitch in the YZ plane, as shown by the pitch P1 in Fig. 2(a). In Fig. 2, the light beams constituting the light beam bundle B1 are arranged in a 3 × 3 matrix, but the number of light beams may be larger than this.

Here, in this embodiment, the zoom lens 14, which is a varifocal optical system, is provided immediately downstream of the phase diffraction element 13, as mentioned above. The pitch of the light spots can be increased or decreased by changing the focal length of this varifocal optical system (magnification of the zoom lens 14), and the pitch of the light beams in the light beam bundle constituting the light beam image 2 can be changed and adjusted as desired, as compared with the pitch P1 in Fig. 2(a), as shown by the light beam bundle B1', in which the spacing between the light beams in Fig. 2(b) is the pitch P1'.

Meanwhile, when the distance between the light beams is adjusted with the zoom lens 14, the surface area of the region irradiated where the irradiated surface S is irradiated with optical energy also changes, and there is a possibility that this surface area will not fall within the allowable range. Here, in this embodiment, an aperture member 18 having an opening (aperture 19) is provided to match the layout of the light beams on the real image plane so that the size and shape of the light beams of the light beam bundle B1 forming the light ray image 2 irradiating the irradiated surface S will be the specified size and shape. More specifically, as shown in Fig. 2(a), the aperture member is replaceable or deformable so that an aperture member 18 in which the apertures 19 are arranged at the pitch P1 is used for a light beam bundle B1 having a pitch P1 between the light beams, and as shown in Fig. 2(b), and an aperture member 18' having apertures 19' arranged at a pitch P1' is used for a light beam bundle B1' having a pitch P1'. Consequently, in addition to the pitch suited to the application, it is also possible to irradiate the surface S with optical energy with an irradiation range (size and shape) suited to the application.

Returning to Fig. 1, in this embodiment, the light beams of the light beam bundle B1 formed once after passing through the zoom lens 14, which is a varifocal optical system, are collimated by the collimator lens 15, and are then converged by the Fθ lens 17 and again imaged on the irradiated surface S. In this description, an optical system for forming light into an image again shall be called an imaging optical system, and in this embodiment, the combination of the collimating lens 15 and the Fθ lens 17 corresponds to this imaging optical system. Also, in this embodiment, the galvano mirror 16 is provided between the collimator lens 15 and the Fθ lens 17.

The galvano mirror 16 has two mirrors, and incident light beams can be emitted in the desired direction by controlling the positions and angles of these mirrors. In this embodiment, the galvano mirror 16 functions as optical energy shifting means for changing the position on the surface S that is irradiated with the optical energy. Providing an optical energy shifting means such as this allows the irradiation position of the optical energy on the transfer substrate 22 having the irradiated surface S to be adjusted.

The transfer substrate 22 is disposed on the downstream side of the Fθ lens 17 in the optical path of the laser beam B emitted from the laser irradiation unit 11, and the receiving substrate 23 is disposed just below the transfer substrate 22, which is further downstream from the transfer substrate 22. The transfer substrate 22 and the receiving substrate 23 are held by a holding means (not shown) (a transfer substrate holding unit and a receiving substrate holding unit).

The transfer substrate 22 is a substrate that is made of glass or another such material and can transmit the light beam bundle B1, and holds the chip 21 on its lower surface side. The chip 21 is a semiconductor chip, for example, and more specifically, an LED chip or the like that constitutes RGB pixels in a display panel.

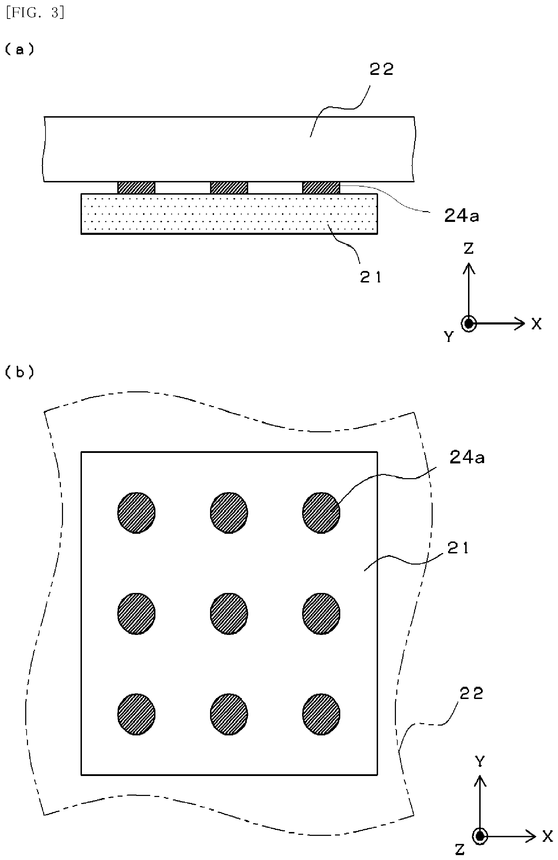

Fig. 3 consists of diagrams illustrating how the chip 21 is held by the transfer substrate 22. Fig. 3(a) is a front view, and Fig. 3(b) is a top view.

Adhesive points 24a (also referred to as holding parts in this description) are provided on the lower surface side of the transfer substrate 22, and the front of the adhesive points 24a adhesively hold the chip 21 so that the transfer substrate 22 holds the chip 21 via the adhesive point 24a. As shown in Fig. 1(a), one transfer substrate 22 holds a plurality of chips 21.

Here, with the transfer substrate 22 of this embodiment, as shown in Figs. 3(a) and 3(b), rather than holding the chip 21 by bonding its entire surface, one chip 21 is adhesively held by a plurality of independent adhesive points 24a in which the surface area of the front of the adhesive points 24a is sufficiently smaller than the surface area of the surface of the chip 21 that is opposite the transfer substrate 22. That is, a holding region for holding one chip 21 is constituted by a plurality of adhesive points 24a (holding parts). In Fig. 3(b), 3 × 3 adhesive points 24a adhesively hold one chip 21. The shape of the front of each adhesive point 24a may be circular as shown in Fig. 3(b), or may be some other shape.

The receiving substrate 23 may be a circuit substrate on which the chip 21 is finally mounted, or an intermediate substrate on which the chip 21 is intermediately held when the transfer is repeated a number of times before mounting on a circuit substrate. The receiving substrate 23 is disposed opposite the transfer substrate 22 with the chip 21 interposed therebetween, and the chip 21 that has been separated from the transfer substrate 22 lands on the side of the receiving substrate 23 that is opposite the transfer substrate 22. A joining material such as an anisotropic conductive film (ACF) or an adhesive material is provided on this landing surface so that the chip 21 can be held.

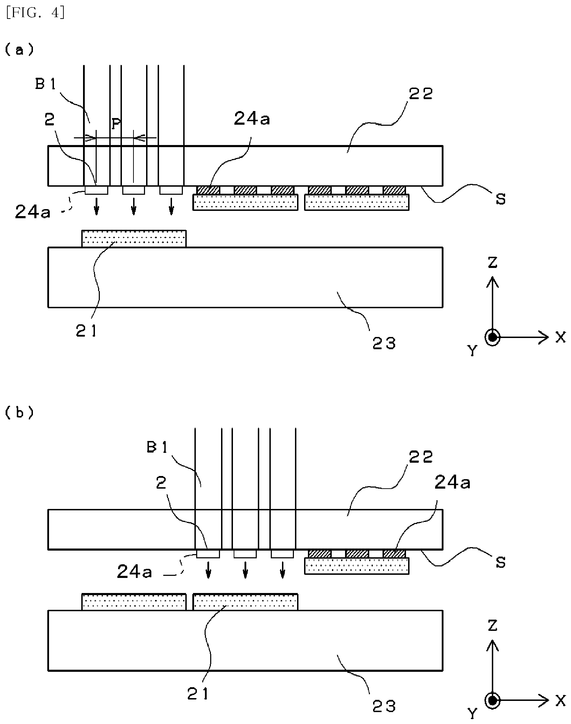

Next, how the chip 21 is transferred by the transfer device 1 will be described with reference to Figs. 4(a) and 4(b).

A laser beam B is emitted from the laser irradiation unit 11, and a light beam image 2 is formed on the irradiated surface S (that is, the surface is irradiated with optical energy), which is the boundary between the transfer substrate 22 and the adhesive points 24a, and as a result the adhesive points 24a are decomposed and generate a gas. In other words, laser ablation occurs. This generation of gas urges the chip 21 when the chip 21 is separated from the transfer substrate 22. This layer such as the adhesive points 24a that is ablated under irradiation with an active energy ray is also called an ablation layer in this description.

In this embodiment, as shown in Fig. 4(a), the light beam bundle B1 is adjusted by the phase diffraction element 13 and the zoom lens 14 so that the number of light beams constituting the light beam image 2 will be the same as the number of adhesive points 24a and the pitch of the light beams (the dimension P in Fig. 4(a)) will be the same as the pitch in the layout of the adhesive points 24a. Consequently, all the adhesive points 24a that adhesively hold one chip 21 are individually and simultaneously irradiated with optical energy. Then, the chip 21 is laser-lifted in a specific direction (downward) by a single emission of the laser beam B, and lands on the receiving substrate 23. As a result, the chip 21 is transferred from the transfer substrate 22 to the receiving substrate 23.

The irradiation position of the optical energy is then shifted by an amount corresponding to the size of the chip 21 by the optical energy shifting means (the galvano mirror 16 in this embodiment), after which the laser irradiation unit 11 emits the laser beam B according to the cycle of the emitted pulse, so that the adjacent chip 21 is irradiated with the light beam image 2 as shown in Fig. 4(b) and transferred to the receiving substrate 23. The movement of the irradiation position of the optical energy and the emission of the laser beam B are repeated in this manner, which continuously transfers chips 21 to the receiving substrate 23.

Here, it is preferable if the irradiation surface area of the light beams constituting the light beam image 2 and the surface area of the fronts of the adhesive point 24a are almost the same, or if the irradiation surface area of the light beams is slightly larger (protruding about 2 to 10 µm from the adhesive points). The shape of the adhesive points 24a is set according to the irradiation surface area of the light beams, or the irradiation surface area of the light beams is set by the aperture member 18 according to the shape of the adhesive points 24a, so as to achieve the above surface area relationship. Consequently, the adhesive points 24a can be completely separated from the chip 21 by being irradiated with optical energy.

On the other hand, if the irradiation surface area of the light beams is too small with respect to the surface area of the adhesive points 24a, laser abrasion may occur only in a part of the adhesive points 24a, in which case there is the risk that the chip 21 will remain held on the transfer substrate 22 via the adhesive points 24a and not be lifted off by laser, or, even if lifted off by laser, the chip 21 will fly off in a direction at an angle to the specified direction.

Also, in this embodiment, it is preferable if the light beam bundle B1 is configured so that the power of the laser beams is uniform. This allows the chip 21 to be separated from all of the adhesive points 24a at the same time and results in uniform thrust being produced during laser ablation, so the chip 21 can be stably lifted off in a specific direction during laser lift-off.

### Second Embodiment

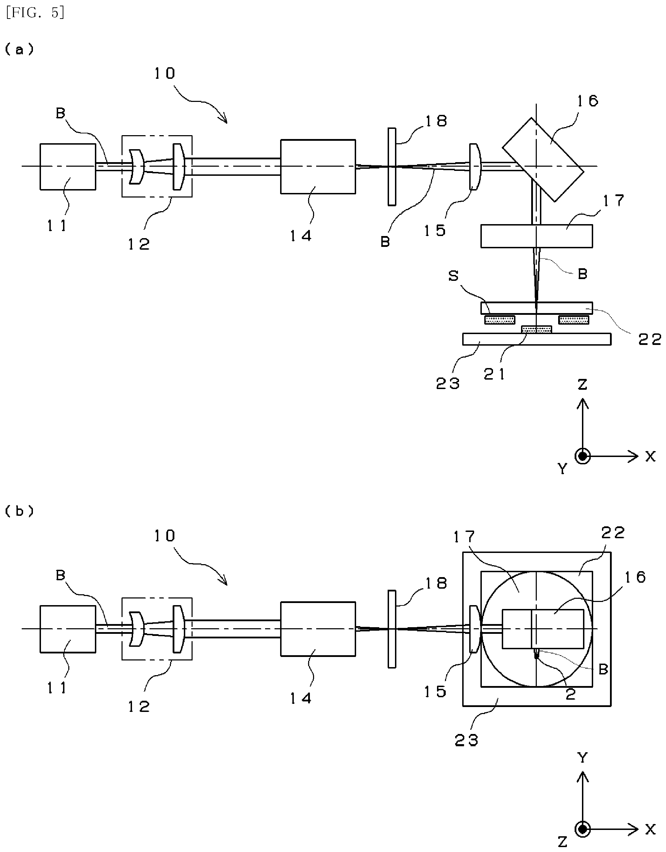

The transfer device 10 in a second embodiment of the present invention will be described with reference to Fig. 5. Fig. 5(a) is a side view of the transfer device 10, and Fig. 5(b) is a top view of the transfer device 10. Those components that are the same as those of the transfer device 1 of the first embodiment will be numbered the same.

The transfer device 10 has a laser irradiation unit 11, a beam expander 12, a zoom lens 14, a collimating lens 15, a galvano mirror 16, and an Fθ lens 17. A laser beam B emitted from the laser irradiation unit 11 passes through the beam expander 12, the zoom lens 14, the collimating lens 15, the galvano mirror 16, and the Fθ lens 17 in that order, then reaches an irradiated surface S, which is a lower surface of the transfer substrate 22. That is, unlike the transfer device 1 in the first embodiment, there is no phase diffraction element 13. Accordingly, the laser beam B emitted from the laser irradiation unit 11 is not split into the light beam bundle B1, and only one light beam constitutes the light beam image 2 on the irradiated surface S. The irradiation position of the light beam image 2 on the irradiated surface S is controlled by the galvano mirror 16, which is an optical energy shifting means.

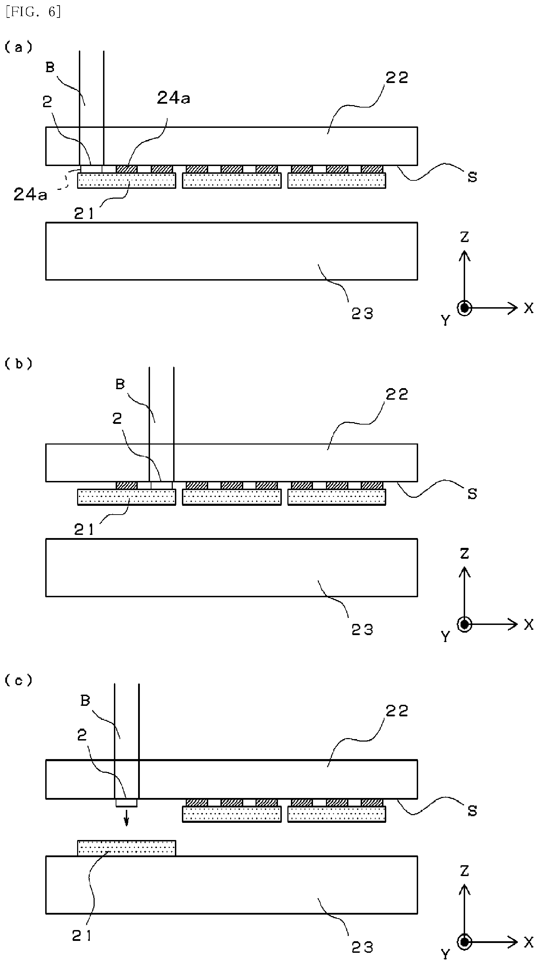

How the chip 21 is transferred by the transfer device 10 will be described with reference to Figs. 6(a) to 6(c).

With this transfer device 10, a plurality of adhesive points 24a holding one chip 21 are individually irradiated one by one with the light beam image 2 (that is, irradiated with optical energy) to produce laser ablation. Once the light beam image 2 irradiates the last remaining adhesive point 21, the chip 21 is completely separated from the transfer substrate 22, moves to the receiving substrate 23 by laser lift-off, and is thus transferred to the receiving substrate 23.

Figs. 6(a) to 6(c) illustrate how the chip 21 is transferred when the chip 21, the transfer substrate 22, and the adhesive points 24a are viewed from the side. Of the three adhesive points 24a shown in Figs. 6(a) to 6(c) as holding each chip 21, first, the adhesive point 24a shown on the left in Fig. 6(a) is irradiated with the light beam image 2 to produce laser ablation.

Next, the adhesive point 24a shown on the right in Fig. 6(b) is irradiated with the light beam image 2, thereby leaving just the middle adhesive point 24a to hold the chip 21.

Finally, the adhesive point 24a shown in the middle in Fig. 6(c) is irradiated with the light beam image 2, and the chip 21 is separated from the transfer substrate 22 and transferred to the receiving substrate 23.

In this transfer mode in which optical energy is applied one at a time to the plurality of adhesive points 24a holding one chip 21, the thrust applied to the chip 21 during laser lift-off is generated when laser ablation is produced at a single adhesive point 24a, so the chip 21 flies to the receiving substrate 23 with a relatively small thrust. As a result, it is possible to prevent the chip 21 from cracking under the impact of landing on the receiving substrate 23.

Also, as shown in Figs. 6(a) to 6(c), the portion where the chip 21 is held can be prevented from being offset to one side by controlling the emission of the optical energy so that the adhesive point 24a that holds the middle part of the chip 21 remains until the end. As a result, when the final adhesive point 24a is irradiated with optical energy and the chip 21 is laser-lifted, the chip 21 will fly stably in the specified direction.

In Figs. 6(a) to 6(c), there are only three adhesive points 24a in one direction for holding one chip 21, but in actual practice, we can imagine a mode in which the adhesive points 24a are disposed at a pitch of 0.1 mm for a chip 21 having a surface area of 2 × 2 mm. In this case, the number of adhesive points 24a is 20 × 20. In such a case, in order to leave the adhesive points 24a that hold the middle portion of the chip 21 until the end, it is preferable for the optical energy 2 to be applied successively, from the adhesive points 24a positioned on the outer side to the adhesive points 24a positioned on the inner side, for example.

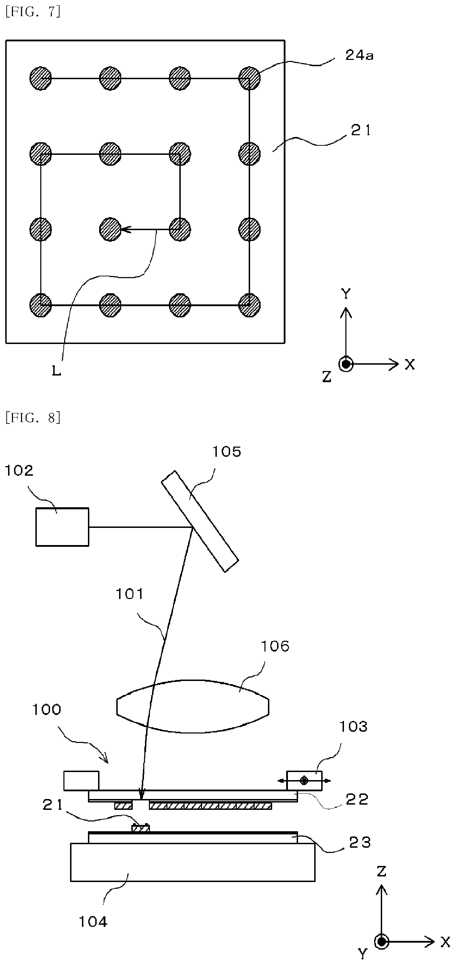

More specifically, as shown in Fig. 7, it is preferable if the plurality of adhesive points 24a holding one chip 21 are irradiated with the light beam image 2 so that the path L of irradiation with the optical energy has a spiral shape. This reliably prevents the portion where the chip 21 is held from being offset to one side until the last adhesive points 24a is irradiated with optical energy, so ultimately the chip 21 can stably fly in the specified direction.

Next, the effect of the transfer device in the first and second embodiments will be described.

The transfer device 1 and the transfer device 10 are both characterized in that the transfer substrate 22 is irradiated with optical energy to transfer the chip 21 held by the transfer substrate 22 to the receiving substrate 23 using laser lift-off, and they both comprise the laser irradiation unit 11 (active energy ray irradiation unit) that emits the laser beam B forming optical energy, and an optical energy shifting means 16 for adjusting the irradiation position of the optical energy on the transfer substrate 22, wherein the chip 21 is held via a plurality of adhesive points 24a provided on the surface of the transfer substrate 22 (irradiated surface S) that is opposite the chip 21, and the laser beam source 11 individually irradiates the plurality of adhesive points 24a holding one chip 21 with optical energy, thereby transferring the chip 21 to the receiving substrate 23 disposed opposite the transfer substrate 22 with the chip 21 interposed therebetween.

With the transfer device 1 and the transfer device 10, the contact surface area between the chip 21 and the transfer substrate 22 via the adhesive points 24a can be reduced, so the output of the laser beam B for transferring a single chip 21 can be reduced and the running cost can be kept low while reliably transferring the chip 21 to the receiving substrate 23.

The transfer device 1 further has the phase diffraction element 13 that converts the laser beam B emitted from the laser beam source 11 into a light beam bundle B1 made up of a plurality of beams, and the light beam bundle B1 simultaneously irradiates all the adhesive points 24a holding one chip 21 with optical energy. This shortens how long it takes for the laser lift-off of a single chip 21.

Also, with the transfer device 10, the laser beam source 11 irradiates the plurality of adhesive points 24a holding one chip 21 with optical energy successively, from the adhesive points 24a positioned on the outer side to the adhesive points 24a positioned on the inner side. This prevents the portion where the chip 21 is held from being offset to one side, and the chip 21 can stably fly off in the specified direction.

With the transfer device 10, the laser beam source 11 irradiates the plurality of adhesive points 24a holding one chip 21 with optical energy so that the path of the optical energy irradiation has a spiral shape. This results in a state in which the portion where the chip 21 is held is always prevented from being offset to one side until the last adhesive point 24a is irradiated with optical energy, so the chip 21 can stably fly off in the specified direction.

With the transfer device 1 and the transfer device 10, the laser beam source 11 irradiates all the adhesive points 24a holding one chip 21 with optical energy of uniform power. This makes control easier, and allows the chip 21 to stably fly off in the specified direction.

### Third Embodiment

The transfer device in a third embodiment of the present invention will be described with reference to Fig. 8.

The transfer device 100 comprises a laser irradiation unit 102 that emits a laser beam 101, a transfer substrate holding unit 103 that holds the transfer substrate 22 and can move in at least the X axis direction and the Y axis direction, a receiving substrate holding unit 104 that holds the receiving substrate 23 so as to be opposite the transfer substrate 22 with a gap therebetween and below the transfer substrate holding unit 103, and a control unit (not shown), wherein the transfer substrate 22 is irradiated with the laser beam 101, which produces ablation in the transfer substrate, and the chip 21 is transferred from the transfer substrate 22 to the receiving substrate 23.

The laser irradiation unit 102 is an embodiment of the active energy ray irradiation unit in the present invention, is a device that emits the laser beam 101, such as an excimer laser (an active energy ray), and is fixed to the transfer device 100. In this embodiment, the laser irradiation unit 102 emits a spot-shaped laser beam 101, and the irradiation position of the laser beam 101 in the X axis direction and the Y axis direction is controlled via a galvano mirror 105 and an Fθ lens 106 whose angle is adjusted by the control unit, and a plurality of chips 21 disposed on the transfer substrate 22 held by the transfer substrate holding unit 103 are selectively irradiated. When the laser beam 101 is incident on the chip 21 of the transfer substrate 22, ablation is produced by the application of active energy (optical energy) between the transfer substrate 22 and the chip 21, and the chip 21 is transferred from the transfer substrate 22 to the receiving substrate 23.

The transfer substrate holding unit 103 has an opening and uses suction to hold the transfer substrate 22 in the vicinity of its outer periphery. The laser beam 101 emitted from the laser irradiation unit 102 can be directed at the transfer substrate 22 held by the transfer substrate holding unit 13 through this opening.

The transfer substrate 22 is a substrate made of glass or another such material that can transmit the laser beam 101, and holds the chip 21 on its lower surface side. An ablation layer 24 (discussed below) is formed on the surface of the transfer substrate 22 where the chip 21 is held, and the surface of this ablation layer 24 is adhesive. The adhesive strength of the surface of the ablation layer 24 provides the holding force for the chip 21, and adhesively holds the chip 21.

Also, the transfer substrate holding unit 103 is moved by a movement mechanism (not shown) relative to the receiving substrate holding unit 104 in at least the X axis direction and the Y axis direction. A control unit (not shown) controls this movement mechanism and adjusts the position of the transfer substrate holding unit 103, thereby adjusting the relative position of the chip 21 held on the transfer substrate 22 with respect to the receiving substrate 23.

The receiving substrate holding unit 104 has a flat upper surface, and holds the receiving substrate 23 such that the receiving surface of the receiving substrate 23 is opposite the ablation layer 24 of the transfer substrate 22 and the chip 21 held by the ablation layer 24 in the course of the transfer of the chip 21. A plurality of suction holes are made in the upper surface of this receiving substrate holding unit 104, and the rear surface of the receiving substrate 23 (the surface to which the chip 21 is not transferred) is held by suction.

Here, the receiving substrate 23 in this embodiment is a substrate made of glass or another such material, and the receiving surface (the surface on the side that receives the chip 21) is adhesive and adhesively holds the chip 21 transferred from the transfer substrate 22.

In this embodiment, the transfer substrate holding unit 103 and the receiving substrate holding unit 104 move relative to each other as a result of only the transfer substrate holding unit 103 moving in the X axis direction and the Y axis direction, but if the receiving substrate 23 is so large in size that the entire surface of the receiving substrate 23 cannot be positioned directly under the irradiation range of the laser beam 101, the receiving substrate holding unit 104 may also be provided with a movement mechanism for movement in the X axis direction and the Y axis direction.

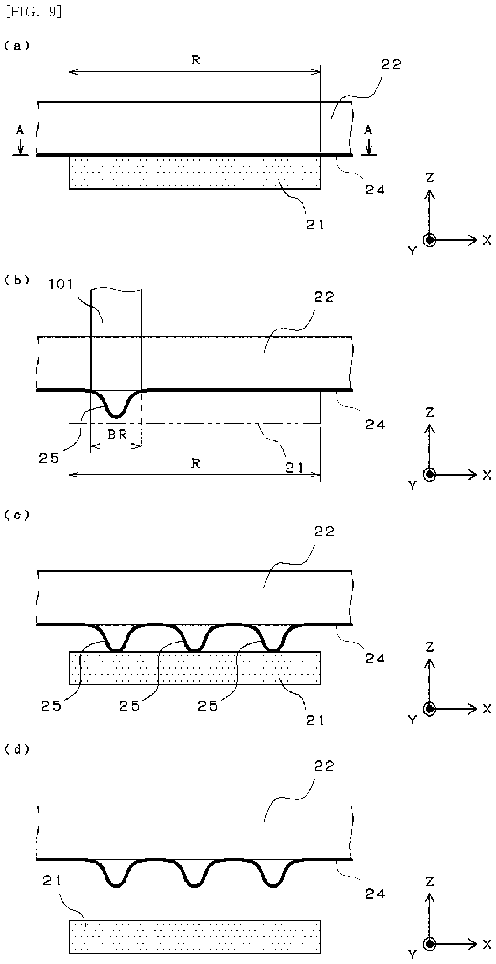

Fig. 9 illustrates the processing of separating the chip 21 from the transfer substrate 22 by the transfer device 100 having the above configuration.

As discussed above, the ablation layer 24 is formed on the surface of the transfer substrate 22 that holds the chip 21. The ablation layer 24 is adhesive on its surface and is ablated upon being irradiated with the laser beam 11.

In this embodiment, the ablation layer 24 is formed over the entire surface of the transfer substrate 22 on which the chip 21 is held. As shown in Fig. 9(a), the range over which one chip 21 is held in the ablation layer 24 is called a holding region R in this description.

Also, in this embodiment, when the ablation layer 24 is irradiated with the laser beam 101, the material of the ablation layer 24 is decomposed near the interface between the ablation layer 24 and the main body of the transfer substrate 22, generating a gas. In other words, ablation occurs. By contrast, the front side of the ablation 24 remains. As a result, as shown in Fig. 9(b), a blister 25 (bulge) is formed corresponding to the irradiation range BR of the laser beam 101.

Here, in this embodiment, as shown in Fig. 9(b), the irradiation range BR of the laser beam 101 is smaller than the holding region R, and the range in which the blister 25 is generated by one irradiation with the laser beam 101 is also smaller than the holding region R. In this embodiment, when the chip 21 is transferred from the transfer substrate 22 to the receiving substrate 23, a plurality of locations within the holding region R are irradiated with the laser beam 101. At this point, the control unit controls the galvano mirror 105, etc., so that the sites within the holding region R that are irradiated by the laser beam 101 will be appropriately spaced apart, and as shown in Fig. 9(c), blisters 25 generated by irradiation with the laser beam 101 can be formed independently for each laser beam irradiation. That is, the blisters 25 can be formed individually, without the blisters 25 being coalesced each other.

As shown in Fig. 9(c), when blisters 25 are formed at a plurality of locations within the holding region R and the chip 21 is lifted up from the transfer substrate 22, the place where the ablation layer 24 and the chip 21 come into contact with each other is limited to the vicinity of the vertex of each blister 25, and the contact surface area between the ablation layer 24 and the chip 21 is greatly reduced compared to before ablation. Also, compared to when one blister 93 is formed in the holding region R as shown in Fig. 18, the contact surface area after laser beam irradiation is much smaller.

Here, since the ability of the ablation layer 24 to adhesively hold the chip 21 is substantially proportional to the contact surface area, the adhesive holding power is greatly reduced after the blisters 25 are generated. When this adhesive holding force becomes smaller than the force for separating the chip 21, which is the sum of the kinetic energy and gravitational force exerted on the chip 21 by the generation of the blisters 25, the chip 21 is separated from the transfer substrate 22 and transferred to the receiving substrate 23 as shown in Fig. 9(d).

As discussed above, the laser beam 101 having an irradiation range BR smaller than the holding region R irradiates a plurality of locations in the holding region R to produce ablation, and this reliably reduces the contact surface area between the ablation layer 24 and the chip 21, allowing the chip 21 to be reliably separated from the transfer substrate 22. Also, since there is no need to increase the laser diameter, an increase in running costs can be prevented.

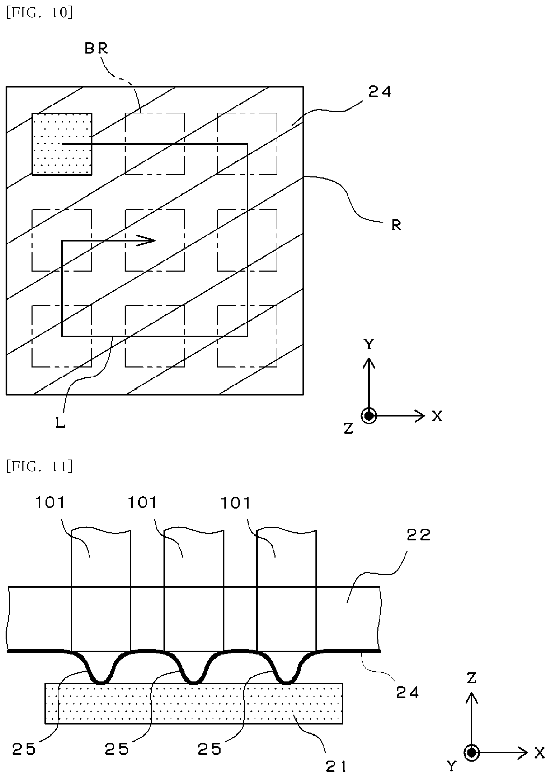

Fig. 10 is a view along the A-A line shown in Fig. 9(a), and shows the procedure of irradiation with the laser beam 101 for transferring one chip 21 with the transfer device 100 of this embodiment.

Fig. 10 shows that the holding region R of the ablation layer 24 is irradiated nine times with the laser beam 101 having the irradiation range BR. At this point, in this embodiment, as indicated by the spiral path L, the holding region R is irradiated with the laser beam 101 successively, from the outside to the inside. Fig. 10 shows that ablation occurs only in the upper-left irradiation range BR, which is the start point, of the nine irradiation ranges BR immediately after the start of transfer.

When the laser beam 101 successively irradiates its targets in this way, the blisters 25 are formed in the order of irradiation with the laser beam 101, however, by irradiating with the laser beam 101 in order from the outside to the inside as in this embodiment, the chip 21 can be prevented from becoming cantilevered during the process up until all the blisters 25 are formed. Consequently, when the chip 21 is peeled off, variance in the falling direction can be prevented, allowing the chip 21 to be transferred to the receiving substrate 23 with good positional accuracy.

Fig. 11 shows procedure by which the laser beam 101 is emitted in another embodiment. In this embodiment, all of the irradiation sites within the holding region R are irradiated simultaneously with the laser beam 11, and a plurality of blisters 25 are formed simultaneously. Thus, forming all the blisters 25 at the same time and peeling off the chip 21 in this way prevents variance in the falling direction when the chip 21 is peeled off, just as above, and the chip 21 can be transferred to the receiving substrate 23 with good positional accuracy.

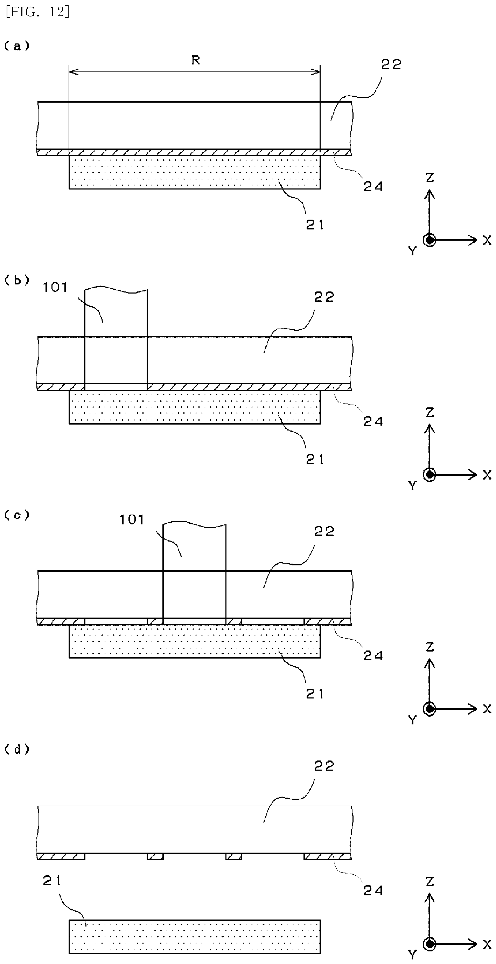

Here, in the transfer device 100 of the present invention, the ablation layer 24 is not limited to a mode in which the blisters 25 are generated by irradiation with the laser beam 101, and as shown in Fig. 12, the mode may be one in which the entire ablation layer 24 in the irradiation range BR is decomposed and disappears as a result of ablation. Even in this case, if the laser beam 101 having the irradiation range BR irradiates a plurality of sites in the holding region R, the ablation layer 24 will steadily disappear in each irradiation range BR as in the process shown in Figs. 12(a) to 12(c), and the contact surface area between the ablation layer 24 and the chip 21 can be reliably reduced. When the adhesive force with which the chip 21 is held by the ablation layer 24, which is proportional to the contact surface area, becomes smaller than the force separating the chip 21, the chip 21 is separated from the transfer substrate 22 as shown in Fig. 12(d), and is transferred to the receiving substrate 23.

Again in this embodiment, the chip 21 can be transferred to the receiving substrate 23 with high positional accuracy by irradiating the holding region R with the laser beam 101 in order from the outside to the inside, or by irradiating all of the irradiation sites in the holding region R with the laser beam 101 at the same time.

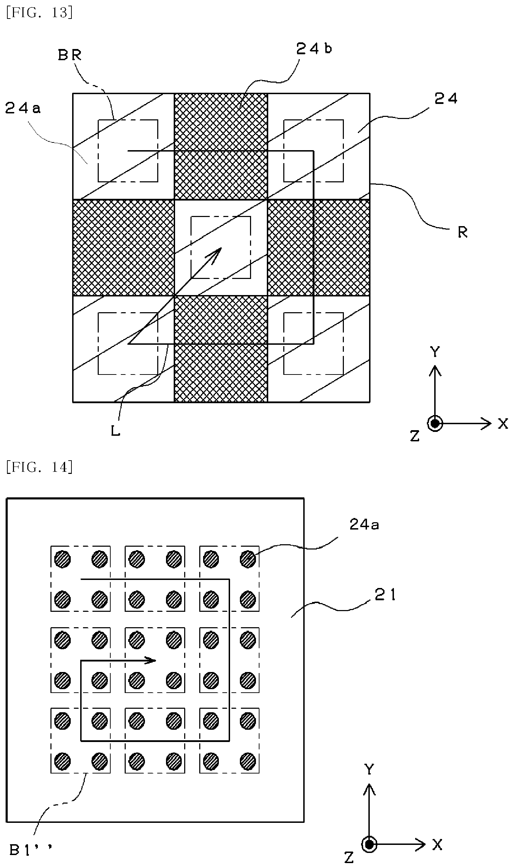

Next, Fig. 13 shows the transfer substrate 22 in another embodiment of the present invention.

In the embodiments described above, the ablation layer 24 is formed over the entire surface of the transfer substrate 22 on which the chip 21 is held. By contrast, with the transfer substrate 22 of this embodiment, in the holding region R, holding parts 24a that have an adhesive holding force with respect to the chip 21 and in which blisters 25 are generated by irradiation with the laser beam 101, and non-holding parts 24b that do not have an adhesive holding force with respect to the chip 21 and in which no ablation or blisters are produced by irradiation with the laser beam 101 coexist. Also, in this embodiment, the holding parts 24a are disposed in a zigzag pattern, and the various holding parts 24a are separated from one another by the non-holding parts 24b.

As shown in Fig. 13, the chip 21 is separated from the transfer substrate 22 by irradiating each holding part 24a with the laser beam 101 having the irradiation range BR to produce a blister 25 in each holding part 24a.

Since the holding parts 24a and the non-holding parts 24b coexist, the non-holding parts 24b hinder the coalescence of the blisters 25 produced in the holding parts 24a. Accordingly, the end result is a mode in which the chip 21 is held by a plurality of small blisters 25, just as in FIG. 9(c), and the contact surface area between the ablation layer 24 and the chip 21 can be greatly reduced compared to before irradiation with the laser beam 101.

Also, the number of sites that have to be irradiated with the laser beam 101 to separate the chip 21 is smaller than in a mode in which the entire holding region R is the ablation layer 24, due to the presence of the non-holding parts 24b, and thus transfer will take less time and running cost can be reduced.

Also, with the transfer substrate 22 of this embodiment, in the process of forming the substrate itself, the ablation layer 24 is first formed over the entire surface of the transfer substrate 22 on the side where the chip 21 is held, just as in the above embodiments. That is, the non-holding parts 24b are made of the same material as the holding parts 24a from the outset. When a site corresponding to a non-holding part 24b is selectively irradiated with ultraviolet rays, that site is cured. Consequently, non-holding parts 24b that are not adhesive and do not produce ablation are formed.

With the transfer device and the transfer substrate described above, an element can be reliably separated from the transfer substrate and transferred to the receiving substrate.

Here, the transfer device and the transfer substrate of the present invention are not limited to the modes described above, and may be in some other mode within the scope of the present invention. For example, the light beam image 2 formed by the phase diffraction element 13 in the transfer device 1 of the first embodiment does not necessarily have to be a matrix of light beams as shown in Fig. 2. Instead, the light beams may be arranged in a zigzag pattern, for instance, to match the layout of the adhesive portions 24.

Also, the transfer substrate holding means may move the transfer substrate 22 in the X axis direction and the Y axis direction to change the position relative to the light beam image 2, so that the transfer substrate holding means functions as an optical energy shifting means. Also, it is preferable if the receiving substrate holding means is also provided with a mechanism for moving the receiving substrate 23 in the X axis direction and the Y axis direction, and the position where the chip 21 is transferred on the receiving substrate 23 is adjusted.

Also, even with a mode in which a plurality of optical energy beams are simultaneously emitted as in the transfer device 1 of the first embodiment, all the adhesive points 24 holding one chip 21 do not necessarily have to be irradiated with optical energy at the same time. For example, as shown in Fig. 14, the number of laser beams forming the light beam bundle B1" (2 × 2 in Fig. 8) may be less than the number of adhesive points 24a holding the chip 21 (6 × 6 in Fig. 8), and the chip 21 may be separated from the transfer substrate 22 by sequentially emitting a plurality of optical energy beams.

Also, when a plurality of adhesive points 24a holding one chip 21 are sequentially irradiated with optical energy, the time interval between optical energy irradiations may or may not be uniform. For example, in order to make the chip 21 fly off stably in the specified direction, the last time interval may be set longer than the other time intervals.

Also, when a plurality of adhesive points 24a holding one chip 21 are sequentially irradiated with optical energy, the irradiation with optical energy does not necessarily have to start from the outer adhesive points 24a toward the inner adhesive points 24a.

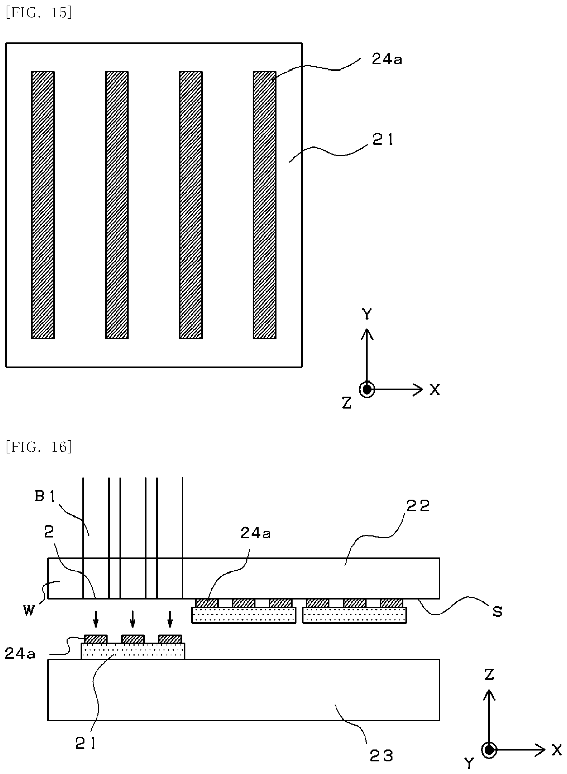

Also, in the above description, the irradiation range of the optical energy is in the form of a spot, but may instead be a line. In this case, it is preferable for the adhesive points also to be in the form of a line, as are the adhesive points 24' shown in Fig. 15.

Also, in the above description, the adhesive points 24a irradiated with the laser beam B or the light beam bundle B1 completely disappeared, but this is not the only option, and as shown in Fig. 16, the laser ablation may be produced only at the contact surface between the adhesive points 24 and a base material W on the transfer substrate 22, so that the adhesive points 24a remain on the chip 21 side even after irradiation with the laser beam B or the light beam bundle B1. Doing this allows the transfer of the chip 21 by laser lift-off to be performed again by sticking the adhesive points 24a remaining on the chip 21 to another base material W later.

Also, in the third embodiment, for example, the power of the laser beam 101 that irradiates a plurality of sites in the holding region R may be uniform, but may instead be non-uniform, such as when the power increases moving toward the middle part of the holding region R.

Also, with the transfer substrate 22 shown in Fig. 13, the holding parts 24a are arranged in a zigzag pattern, but this is not the only option, and the holding parts 24a may instead be arranged in a matrix pattern, for example. Alternatively, they may be arranged irregularly. Also, the holding parts 24a do not need to be completely isolated from each other. For example, the corners may be slightly connected to each other to the extent that the coalescence of the blisters 25 can still be prevented.

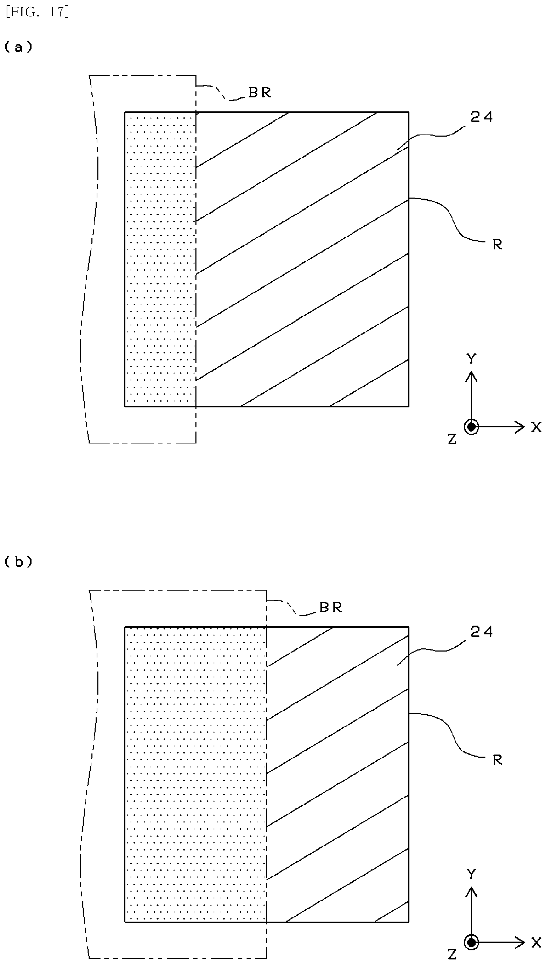

Also, in the above description, the irradiation range BR of the laser beam 101 is smaller than the holding region R, but this is not necessarily the case, and the irradiation range BR of the laser beam 101 may be larger than the holding region R. As shown in Figs. 17(a) and 17(b), the irradiation range BR may be slightly shifted while being irradiated with the laser beam 101, so that ablation is produced successively at a plurality of locations in the holding region R.

### [DESCRIPTION OF THE REFERENCE NUMERALS]

1 transfer device
2 light beam image
10 transfer device
11 laser irradiation unit (active energy ray irradiation unit)
12 beam expander
13 phase diffraction element
14 zoom lens (varifocal optical system)
15 collimating lens
16 galvano mirror (optical energy shifting means)
17 Fθ lens
18 aperture member
18' aperture member
19 aperture
19' aperture
21 chip (element)
22 transfer substrate
23 receiving substrate
24 ablation layer
24a adhesive point (holding part)
24b non-holding part
25 blister
91 element
92 transfer substrate
93 blister
100 transfer device
101 laser beam (active energy ray)
102 laser irradiation unit (active energy ray irradiation unit)
103 transfer substrate holding unit
104 receiving substrate holding unit
105 galvano mirror
106 Fθ lens
B laser beam
B1 light beam bundle
B1' light beam bundle
B1" light beam bundle
BR irradiation range
R holding region
L path
S irradiated surface
W base material

## Claims

1. A transfer device that irradiates an ablation layer of a transfer substrate with an active energy ray to cause ablation, thereby transferring an element held by the ablation layer from the transfer substrate to a receiving substrate, the transfer device comprising:
a transfer substrate holding unit that holds the transfer substrate;
a receiving substrate holding unit that holds the receiving substrate such that the ablation layer of the transfer substrate is opposite the receiving substrate; and
an active energy ray irradiation unit that irradiates the ablation layer of the transfer substrate held by the transfer substrate holding unit with an active energy ray, wherein
the active energy ray irradiation unit irradiates the ablation layer with the active energy ray at a plurality of locations in a holding region in which one element is held.

2. The transfer device according to claim 1, wherein
an irradiation range of the active energy ray is smaller than the holding region.

3. The transfer device according to claim 1 or 2, wherein
the ablation layer disappears under the ablation.

4. The transfer device according to claim 1 or 2, wherein
the ablation layer blisters under the ablation.

5. The transfer device according to claim 4, wherein
the active energy ray irradiation unit is configured such that the locations irradiated with the active energy ray are controlled so that the blistering is formed each time the active energy ray is emitted.

6. The transfer device according to any one of claims 1 to 5, wherein
the ablation layer is made up of a plurality of independent holding parts, and the plurality of holding parts holding one element are individually irradiated with the active energy ray.

7. The transfer device according to claim 4 or 5, wherein
in the holding region of the ablation layer, holding parts having an element holding force and in which blistering occurs under irradiation with the active energy ray, and non-holding parts having no element holding force and in which blistering is not produced by the active energy ray coexist.

8. The transfer device according to claim 6 or 7, wherein
the active energy ray irradiation unit irradiates the plurality of holding parts holding one element with the active energy ray in a specific order.

9. The transfer device according to claim 8, wherein
the active energy ray irradiation unit irradiates the plurality of the holding parts holding one element with the active energy ray in order from an outer holding part to an inner holding part.

10. The transfer device according to claim 8 or 9, wherein
the active energy ray irradiation unit irradiates the plurality of holding parts holding one element with the active energy ray so that a path of irradiation with the active energy ray has a spiral shape.

11. The transfer device according to claim 6 or 7, wherein
the active energy ray emitted from the active energy ray irradiation unit is converted into an energy ray bundle formed of a plurality of active energy rays, and the energy ray bundle simultaneously irradiates all of the holding parts holding one element.

12. The transfer device according to any one of claims 6 to 11, wherein
the active energy ray irradiation unit irradiates all of the holding parts holding one element with an active energy ray of uniform power.

13. A transfer device that irradiates a transfer substrate with optical energy to transfer a transfer object held by the transfer substrate to a receiving substrate using laser lift-off, the transfer device comprising:
a laser beam source that emits laser beam that forms the optical energy; and
an optical energy shifting means for adjusting an irradiation position of the optical energy on the transfer substrate, wherein
the transfer object is held on the transfer substrate via a plurality of adhesive points provided on a surface of the transfer substrate that is opposite the transfer object, and the laser beam source individually irradiates the plurality of adhesive points holding the one transfer object with the optical energy, thereby transferring the transfer object to the receiving substrate that is disposed opposite the transfer substrate with the transfer object sandwiched therebetween.

14. A transfer substrate that holds an element with an ablation layer that undergoes ablation when irradiated with an active energy ray, wherein
in a holding region for holding one element in the ablation layer,
holding parts having an element holding force and in which blistering occurs under irradiation with the active energy ray, and non-holding parts having no element holding force and in which blistering is not produced by the active energy ray coexist.
